# EUROPEAN PATENT APPLICATION

(11) **EP 4 578 714 A1**
(43) Date of publication of application: **02.07.2025**
(21) Application number: 24221749.5
(22) Date of filing: 19.12.2024
(51) Int. Cl.: B60L 53/16, B60L 53/18, B60L 53/302

(54) **COOLING MODULE, ELECTRICAL CONNECTION MODULE AND CHARGING DEVICE**

(30) Priority: 29.12.2023 CN 202311861680
(71) Applicant: Tyco Electronics (Suzhou) Ltd., Suzhou City, Jiangsu Province 215126 (CN); Tyco Electronics Technology (SIP) Ltd., Suzhou 215026 (CN); Tyco Electronics (Shanghai) Co., Ltd., Pilot Free Trade Zone Shanghai 200131 (CN)
(72) Inventor: Wu, Super, Suzhou, 32 215123 (CN); Zhu, Fangyue, Shanghai, 200233 (CN); Wang, Jinshun, Suzhou, 32 215123 (CN)
(74) Representative: Grünecker Patent- und Rechtsanwälte PartG mbB

(57) **Abstract**

The present invention discloses a cooling module, an electrical connection module, and a charging device. The cooling module comprises of: a cooling box (1) comprising a containing chamber (101) for containing cooling liquid, an inlet pipe joint (11) and a cooling core pipe joint (12) communicated with the containing chamber (101); and a fixing device (2) which is detachably installed on the cooling box (1) for fixing a single charging terminal (3) to the cooling box (1), so that the charging terminal (3) is in thermal contact with the cooling box (1). The inlet pipe joint (11) is used to connect with an inlet pipe (5) for supplying the cooling liquid, and the cooling core pipe joint (12) is used to connect with a cooling core pipe (42) of a charging cable (4), so that the cooling liquid can flow through the containing chamber (101) and the cooling core pipe (42) of the charging cable (4) to cool the charging terminal (3) and the charging cable (4). In the present invention, the cooling module structure in the charging device is simple and can be replaced separately, reducing the maintenance cost of the charging device in the later stage and making it very convenient to use.

## Description

### CROSS-REFERENCE TO RELATED APPLICATION

This application claims the benefit of Chinese Patent Application No. CN202311861680.1 filed on December 29, 2023 in the State Intellectual Property Office of China, the whole disclosure of which is incorporated herein by reference.

### BACKGROUND OF THE INVENTION

### Field of the Invention

The present invention relates to a cooling module, an electrical connection module comprising the cooling module and a charging device comprising the electrical connection module.

### Description of the Related Art

In the prior art, the charging seat usually includes a charging seat housing, a charging terminal set in the charging seat housing, and a charging cable electrically connected to the charging terminal. In order to improve the charging speed, it is necessary to increase the charging current. Currently, the charging current requirement is as high as 600A, and it may be further increased to 1000A in the future. When this high current flows through the charging cable and charging terminal, it will cause a sharp rise in the temperature inside the charging seat housing and the temperature of the charging cable. In order to prevent excessive temperature rise, in the prior art, the diameter of the charging cable is usually increased, but this will increase the volume and weight of the charging seat product, and lead to higher costs.

In order to improve the cooling performance of the charging seat, a liquid cooled charging seat has recently been proposed. In the housing of the liquid cooled charging seat, there is a containing chamber for accommodating the cooling liquid. The containing chamber has an inlet pipe joint for connecting with the cooling liquid inlet pipe and an outlet pipe joint for connecting with the cooling liquid outlet pipe. This technical solution will result in a complex housing structure of the charging seat, and the later maintenance cost is high, making it very inconvenient to use.

### SUMMARY OF THE INVENTION

The present invention has been made to overcome or alleviate at least one aspect of the above mentioned disadvantages.

According to an aspect of the present invention, there is provided a cooling module. The cooling module comprises of: a cooling box comprising a containing chamber for containing cooling liquid, an inlet pipe joint and a cooling core pipe joint communicated with the containing chamber; and a fixing device which is detachably installed on the cooling box for fixing a single charging terminal to the cooling box, so that the charging terminal is in thermal contact with the cooling box. The inlet pipe joint is used to connect with an inlet pipe for supplying the cooling liquid, and the cooling core pipe joint is used to connect with a cooling core pipe of a charging cable, so that the cooling liquid can flow through the containing chamber and the cooling core pipe of the charging cable to cool the charging terminal and the charging cable.

According to an exemplary embodiment of the present invention, the cooling box comprises of a box body which is used to define the containing chamber and has an opening; and a cover plate which is installed on the opening of the box body. The fixing device is used to fix the charging terminal to the outer surface of the cover plate, and the cover plate is used to make thermal contact with the charging terminal, so that the heat of the charging terminal can be transferred to the cooling liquid inside the cooling box through the cover plate.

According to another exemplary embodiment of the present invention, the inlet pipe joint and the cooling core pipe joint are integrally formed with the box body, so that the inlet pipe joint and the cooling core pipe joint become part of the box body; or the inlet pipe joint and the cooling core pipe joint are respectively connected to the box body and communicated with the containing chamber.

According to another exemplary embodiment of the present invention, the cover plate is an insulation component that can conduct heat but not electricity, and the box body is an insulation component that cannot conduct heat and electricity.

According to another exemplary embodiment of the present invention, the cover plate is a ceramic component that can conduct heat but not electricity, and the box body is an injection molded component that cannot conduct heat and electricity.

According to another exemplary embodiment of the present invention, the cooling box further comprises a sealing ring which is set around the opening of the box body and compressed between the box body and the cover plate to achieve sealing between the box body and the cover plate.

According to another exemplary embodiment of the present invention, a sealing ring installation groove is formed on at least one of the box body and the cover plate, and the sealing ring is positioned and installed in the sealing ring installation groove.

According to another exemplary embodiment of the present invention, a threaded hole is formed in the box body, and a connection hole is formed in the cover plate, the cooling module further comprises a threaded connecting piece, which passes through the connection hole and is threaded into the threaded hole to fix the cover plate to the box body.

According to another exemplary embodiment of the present invention, the connection hole is a countersunk hole, so that the head of the threaded connecting piece is hidden in the connection hole; the top surface of the head of the threaded connecting piece is lower than or flush with the outer surface of the cover plate, so that the outer surface of the cover plate can reliably make thermal contact with the charging terminal.

According to another exemplary embodiment of the present invention, the fixing device comprises of a U-shaped component which is fastened onto the box body and formed with a threaded connection hole; and a bolt which is connected to the threaded connection hole for pushing the charging terminal onto the cover plate of the cooling box, so that there is a predetermined contact force between the charging terminal and the cover plate.

According to another exemplary embodiment of the present invention, the U-shaped component comprises: a pair of side plates which are respectively fastened to both sides of the box body; and a top plate connected between the top of the pair of side plates and facing the cover plate of the cooling box. The threaded connection hole is formed in the top plate of the U-shaped component and the axis of the threaded connection hole is perpendicular to the outer surface of the cover plate.

According to another exemplary embodiment of the present invention, the pair of side plates of the U-shaped component are respectively formed with snap slots, and protrusions are respectively formed on both sides of the box body of the cooling box, the protrusions are engaged with the snap slots to fix the pair of side plates of the U-shaped component to both sides of the box body of the cooling box.

According to another aspect of the present invention, there is provided an electrical connection module. The electrical connection module comprises: the above cooling module; a charging terminal which is fixed to the cooling box of the cooling module by the fixing device of the cooling module; and a charging cable comprising a cooling core pipe connected to the cooling core pipe joint of the cooling module and a conductor core connected to the charging terminal. The charging terminal is in thermal contact with the cooling box, so that the heat of the charging terminal can be transferred to the cooling liquid inside the cooling box.

According to another exemplary embodiment of the present invention, the conductor core has a flat connection end, and the charging terminal has a flat welding end, the connection end of the conductor core is stacked and welded to the top surface of the welding end of the charging terminal; the bolt of the fixing device is pressed against the connection end of the conductor core, so as to push the welding end of the charging terminal onto the cover plate of the cooling box through the connection end of the conductor core, so that the bottom surface of the welding end of the charging terminal is in direct thermal contact with the outer surface of the cover plate.

According to another exemplary embodiment of the present invention, the conductor core of the charging cable is tubular, and the cooling core pipe is set in the tubular conductor core, the charging cable also includes an outer insulation layer wrapped around the outside of the conductor core.

According to another exemplary embodiment of the present invention, the electrical connection module further comprises an inlet pipe which is connected to the inlet pipe joint of the cooling module, and is used to supply cooling liquid to the cooling box and the cooling core pipe of the charging cable.

According to another exemplary embodiment of the present invention, the electrical connection module further comprises an elastic seal which is formed with a first through-hole that allows the charging cable to pass through and a second through-hole that allows the inlet pipe to pass through. The charging cable and the inlet pipe pass through the elastic seal, and the elastic seal is adapted to be installed into a rear port of a housing of a charging device to seal the rear port of the housing.

According to another exemplary embodiment of the present invention, the electrical connection module further comprises a rear end cap which is formed with a third through-hole that allows the charging cable to pass through and a fourth through-hole that allows the inlet pipe to pass through, the charging cable and the inlet pipe pass through the rear end cap, the rear end cap is adapted to be locked onto the peripheral wall of the rear port of the housing to fix the elastic seal in the rear port of the housing.

According to another aspect of the present invention, there is provided a charging device. The charging device comprises of a housing; and the above electrical connection module inserted into the housing.

According to an exemplary embodiment of the present invention, the housing has multiple mounting holes, and the charging device comprises multiple electrical connection modules, which are respectively inserted into the multiple mounting holes of the housing.

According to another exemplary embodiment of the present invention, the mounting hole has a front port and a rear port that are opposite in its axial direction, the electrical connection module is inserted into the mounting hole from the rear port of the mounting hole, and the charging terminal is suitable for mating with a mating terminal inserted from the front port of the mounting hole.

According to another exemplary embodiment of the present invention, the charging device is a charging seat suitable for mating with a charging gun, and the charging terminal is suitable for mating with a mating terminal in the charging gun.

According to another exemplary embodiment of the present invention, the charging device is a charging gun suitable for mating with a charging seat, and the charging terminal is suitable for mating with a mating terminal in the charging seat.

In the aforementioned exemplary embodiments according to the present invention, the cooling module structure in the charging device is simple and can be replaced separately, reducing maintenance costs in the later stage and making it very convenient to use.

### BRIEF DESCRIPTION OF THE DRAWINGS

The above and other features of the present invention will become more apparent by describing in detail exemplary embodiments thereof with reference to the accompanying drawings, in which:
Figure 1 shows an illustrative perspective view of an electrical connection module according to an exemplary embodiment of the present invention;
Figure 2 shows a longitudinal sectional view of an electrical connection module according to an exemplary embodiment of the present invention;
Figure 3 shows an illustrative exploded view of an electrical connection module according to an exemplary embodiment of the present invention;
Figure 4 shows a cross-sectional view of the electrical connection module shown in Figure 3;
Figure 5 shows an illustrative perspective view of a cooling module according to an exemplary embodiment of the present invention;
Figure 6 shows an illustrative exploded view of a cooling module according to an exemplary embodiment of the present invention;
Figure 7 shows an illustrative perspective view of an electrical connection module according to an exemplary embodiment of the present invention, in which an elastic seal and a rear end cap are shown; and
Figure 8 shows a longitudinal sectional view of a charging device according to an exemplary embodiment of the present invention.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a cooling module. The cooling module comprises of a cooling box comprising a containing chamber for containing cooling liquid, an inlet pipe joint and a cooling core pipe joint communicated with the containing chamber; and a fixing device which is detachably installed on the cooling box for fixing a single charging terminal to the cooling box, so that the charging terminal is in thermal contact with the cooling box. The inlet pipe joint is used to connect with an inlet pipe for supplying the cooling liquid, and the cooling core pipe joint is used to connect with a cooling core pipe of a charging cable, so that the cooling liquid can flow through the containing chamber and the cooling core pipe of the charging cable to cool the charging terminal and the charging cable.

According to another general concept of the present invention, there is provided an electrical connection module. The electrical connection module comprises: the above cooling module; a charging terminal which is fixed to the cooling box of the cooling module by the fixing device of the cooling module; and a charging cable comprising a cooling core pipe connected to the cooling core pipe joint of the cooling module and a conductor core connected to the charging terminal. The charging terminal is in thermal contact with the cooling box, so that the heat of the charging terminal can be transferred to the cooling liquid inside the cooling box.

According to another general concept of the present invention, there is provided a charging device. The charging device comprises of a housing; and the above electrical connection module inserted into the housing.

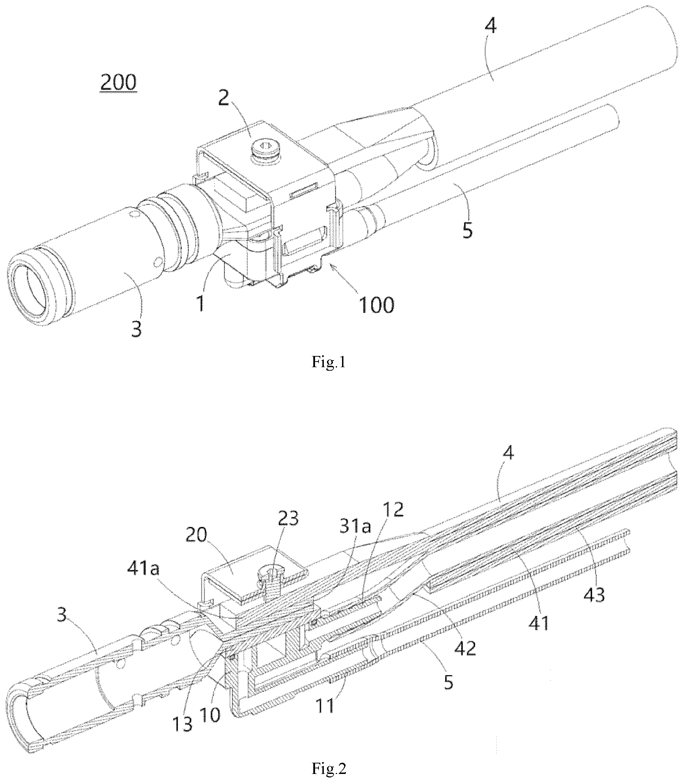

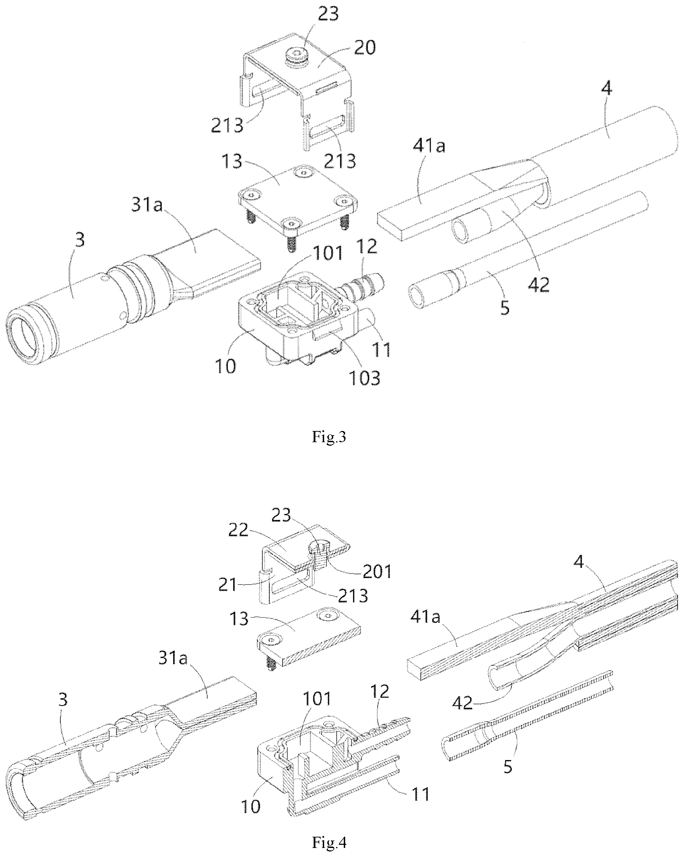

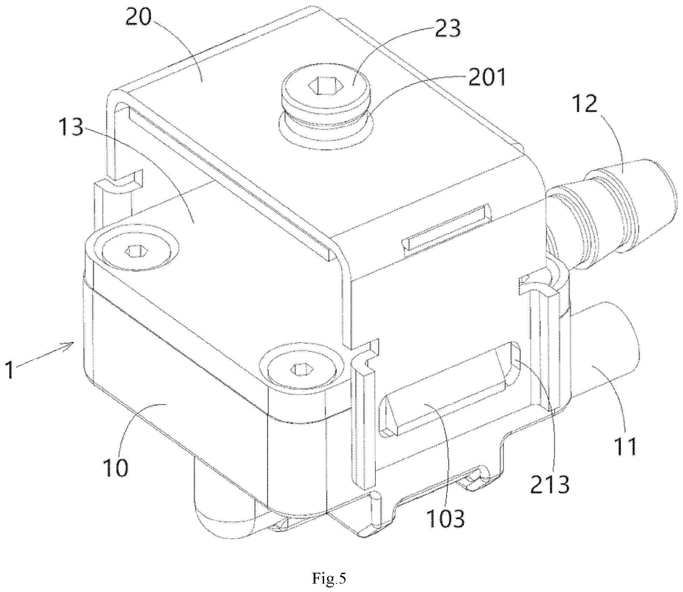

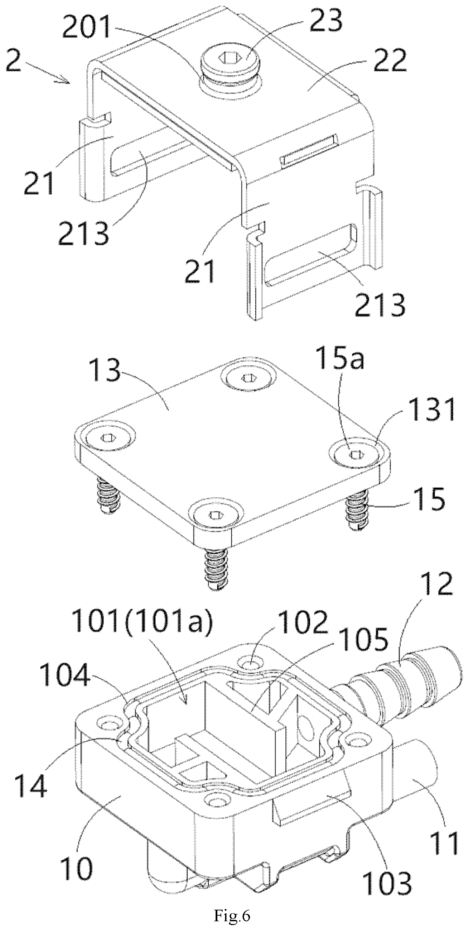

Figure 1 shows an illustrative perspective view of an electrical connection module 200 according to an exemplary embodiment of the present invention; Figure 2 shows a longitudinal sectional view of an electrical connection module 200 according to an exemplary embodiment of the present invention; Figure 3 shows an illustrative exploded view of an electrical connection module 200 according to an exemplary embodiment of the present invention; Figure 4 shows a cross-sectional view of the electrical connection module 200 shown in Figure 3; Figure 5 shows an illustrative perspective view of a cooling module 100 according to an exemplary embodiment of the present invention; Figure 6 shows an illustrative exploded view of a cooling module 100 according to an exemplary embodiment of the present invention.

As shown in Figures 1 to 6, in an exemplary embodiment of the present invention, a cooling module 100 is disclosed. The cooling module 100 includes a cooling box 1 and a fixing device 2. The cooling box 1 has a containing chamber 101 for accommodating cooling liquid, and an inlet pipe joint 11 and a cooling core pipe joint 12 communicated with the containing chamber 101. The fixing device 2 is detachably installed on the cooling box 1, used to fix a single charging terminal 3 to the cooling box 1, so that the charging terminal 3 is in thermal contact with the cooling box 1.

As shown in Figures 1 to 6, in the illustrated embodiment, the inlet pipe joint 11 is used to connect with an inlet pipe 5 for supplying cooling liquid, and the cooling core pipe joint 12 is used to connect with a cooling core pipe 42 of a charging cable 4, so that the cooling liquid can flow through the containing chamber 101 and the cooling core pipe 42 of the charging cable 4 to cool the charging terminal 3 and the charging cable 4.

As shown in Figures 1 to 6, in the illustrated embodiment, the cooling box 1 includes a box body 10 and a cover plate 13. The box body 10 is used to define the containing chamber 101 and has an opening 101a. The cover plate 13 is installed on the opening 101a of the box body 10 to cover the opening. The fixing device 2 is used to fix the charging terminal 3 to the outer surface of the cover plate 13. The cover plate 13 is used to make thermal contact with the charging terminal 3, so that the heat of the charging terminal 3 can be transferred to the cooling liquid inside the cooling box 1 through the cover plate 13.

As shown in Figures 1 to 6, in the illustrated embodiment, the inlet pipe joint 11 and the cooling core pipe joint 12 are integrally formed with the box body 10, so that the inlet pipe joint 11 and the cooling core pipe joint 12 become part of the box body 10. However, the present invention is not limited to the illustrated embodiment. For example, the inlet pipe joint 11 and the cooling core pipe joint 12 may be respectively connected to the box body 10 and communicated with the containing chamber 101.

As shown in Figures 1 to 6, in the illustrated embodiment, the cover plate 13 is an insulation component that can conduct heat but not electricity, and the box body 10 is an insulation component that cannot conduct heat and electricity. For example, the cover plate 13 can be a ceramic component that can conduct heat but not electricity, and the box body 10 can be an injection molded component that cannot conduct heat and electricity.

As shown in Figures 1 to 6, in the illustrated embodiment, the cooling box 1 further includes a sealing ring 14, which is arranged around the opening 101a of the box body 10 and compressed between the box body 10 and the cover plate 13 to achieve sealing between the box body 10 and the cover plate 13.

As shown in Figures 1 to 6, in the illustrated embodiment, a sealing ring installation groove 104 is formed on at least one of the box body 10 and the cover plate 13, and the sealing ring 14 is positioned and installed in the sealing ring installation groove 104.

As shown in Figures 1 to 6, in the illustrated embodiment, a threaded hole 102 is formed in the box body 10, and a connection hole 131 is formed in the cover plate 13. The cooling module 100 also includes a threaded connecting piece 15, which passes through the connection hole 131 and is threaded into the threaded hole 102 to fix the cover plate 13 to the box body 10.

As shown in Figures 1 to 6, in the illustrated embodiment, the connection hole 131 is a countersunk hole, so that the head 15a of the threaded connecting piece 15 is hidden in the connection hole 131. The top surface of the head 15a of the threaded connecting piece 15 is lower than or flush with the outer surface of the cover plate 13, so that the outer surface of the cover plate 13 can reliably make thermal contact with the charging terminal 3.

As shown in Figures 1 to 6, in the illustrated embodiment, the fixing device 2 includes a U-shaped component 20 and a bolt 23. The U-shaped component 20 is fastened onto the box body 10 and has a threaded connection hole 201 formed in it. The bolt 23 is connected to threaded connection hole 201, used to push the charging terminal 3 onto the cover plate 13 of the cooling box 1, so that there is a predetermined contact force between the charging terminal 3 and the cover plate 13. In the illustrated embodiment, in order to improve the rigidity of the cover plate 13, a support wall 105 is formed inside the box body 10, and the support wall 105 is supported on the inner surface of the cover plate 13 to prevent deformation of the cover plate 13.

As shown in Figures 1 to 6, in the illustrated embodiment, the U-shaped component 20 includes a pair of side plates 21 and a top plate 22. The pair of side plates 21 are respectively fastened to both sides of the box body 10. The top plate 22 is connected between the top of the pair of side plates 21 and faces the cover plate 13 of the cooling box 1. The threaded connection hole 201 is formed in the top plate 22 of the U-shaped component 20 and its axis is perpendicular to the outer surface of the cover plate 13.

As shown in Figures 1 to 6, in the illustrated embodiment, snap slots 213 are respectively formed on the pair of side plates 21 of the U-shaped component 20, and protrusions 103 are respectively formed on both sides of the box body 10 of the cooling box 1. The protrusions 103 are engaged with the slots 213 to fix the pair of side plates 21 of the U-shaped component 20 to both sides of the box body 10 of the cooling box 1.

As shown in Figures 1 to 6, in another exemplary embodiment of the present invention, an electrical connection module 200 is also disclosed. The electrical connection module includes: the cooling module 100, a charging terminal 3, and a charging cable 4. The charging terminal 3 is fixed to the cooling box 1 of the cooling module 100 by the fixing device 2 of the cooling module 100. The charging cable 4 includes a cooling core pipe 42 connected to the cooling core pipe joint 12 of the cooling module 100 and a conductor core 41 connected to the charging terminal 3. The charging terminal 3 is in thermal contact with the cooling box 1, allowing the heat of the charging terminal 3 to be transferred to the cooling liquid inside the cooling box 1.

As shown in Figures 1 to 6, in the illustrated embodiment, the conductor core 41 has a flat connection end 41b, and the charging terminal 3 has a flat welding end 31a. The connection end 41a of the conductor core 41 is stacked and welded to the top surface of the welding end 31a of the charging terminal 3. The bolt 23 of the fixing device 2 is pressed against the connection end 41a of the conductor core 41, so as to push the welding end 31a of the charging terminal 3 onto the cover plate 13 of the cooling box 1 through the connection end 41a of the conductor core 41, so that the bottom surface of the welding end 31a of the charging terminal 3 is in direct thermal contact with the outer surface of the cover plate 13.

As shown in Figures 1 to 6, in the illustrated embodiment, the conductor core 41 of the charging cable 4 is tubular, and the cooling core pipe 42 is set in the tubular conductor core 41. The charging cable 4 also includes an outer insulation layer 43 wrapped around the outside of the conductor core 41.

As shown in Figures 1 to 6, in the illustrated embodiment, the electrical connection module 200 further includes an inlet pipe 5, which is connected to the inlet pipe joint 11 of the cooling module 100 for supplying cooling liquid to the cooling box 1 and the cooling core pipe 42 of the charging cable 4.

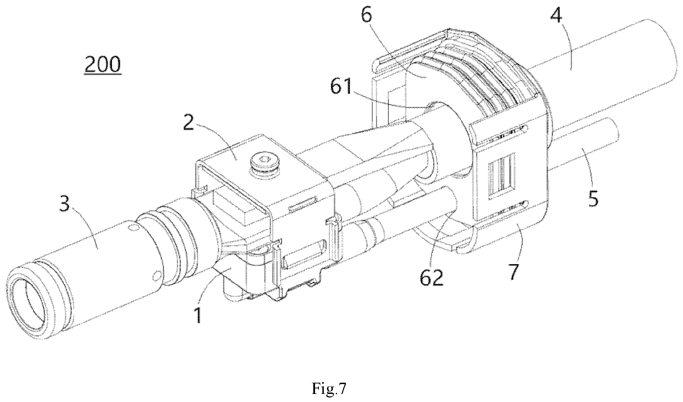

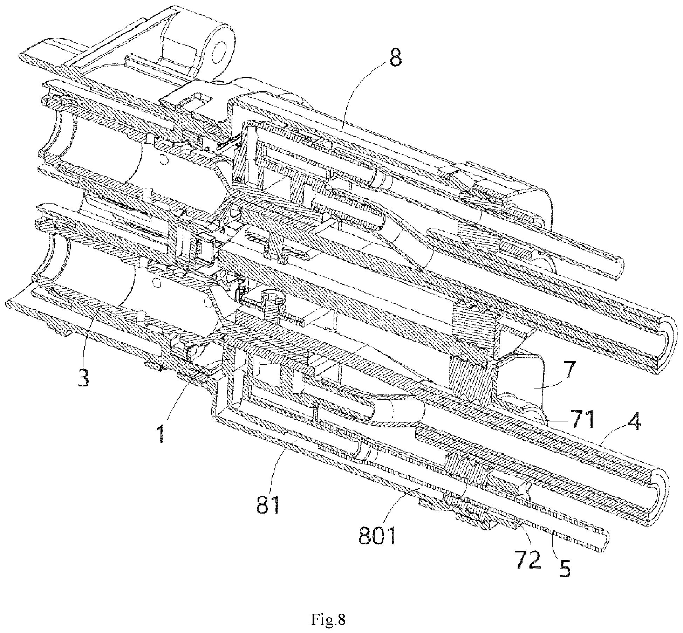

Figure 7 shows an illustrative perspective view of an electrical connection module 200 according to an exemplary embodiment of the present invention, in which an elastic seal 6 and a rear end cap 7 are shown; Figure 8 shows a longitudinal sectional view of a charging device according to an exemplary embodiment of the present invention.

As shown in Figures 1 to 8, in the illustrated embodiment, the electrical connection module 200 further includes an elastic seal 6, which is formed with a first through-hole 61 allowing the charging cable 4 to pass through and a second through-hole 62 allowing the liquid inlet pipe 5 to pass through. The charging cable 4 and the inlet pipe 5 pass through the elastic seal 6, and the elastic seal 6 is suitable for being installed into the rear port 801 of the charging device housing 8 to seal the rear port 801 of the housing 8.

As shown in Figures 1 to 8, in the illustrated embodiment, the electrical connection module 200 further includes a rear end cap 7, which is formed with a third through-hole 71 allowing the charging cable 4 to pass through and a fourth through-hole 72 allowing the liquid inlet pipe 5 to pass through. The charging cable 4 and the inlet pipe 5 pass through the rear end cap 7, which is adapted to be locked onto the peripheral wall of the rear port 801 of the housing 8 to fix the elastic seal 6 in the rear port 801 of the housing 8.

As shown in Figures 1 to 8, in another exemplary embodiment of the present invention, a charging device is also disclosed. The charging device comprises a housing 8 and an electrical connection module 200, wherein the electrical connection module 200 is inserted into the housing 8.

As shown in Figures 1 to 8, in the illustrated embodiment, the housing 8 has multiple mounting holes 81, and the charging device includes multiple electrical connection modules 200, which are respectively inserted into the multiple mounting holes 81 of the housing 8.

As shown in Figures 1 to 8, in the illustrated embodiment, the mounting hole 81 has a front port and a rear port 801 that are opposite in its axial direction. The electrical connection module 200 is inserted into the mounting hole 81 from the rear port 801 of the mounting hole 81, and the charging terminal 3 is suitable for mating with a mating terminal (not shown) inserted from the front port of the mounting hole 81.

As shown in Figures 1 to 8, in an exemplary embodiment, the charging device is a charging seat suitable for mating with a charging gun, and the charging terminal 3 is suitable for mating with a mating terminal in the charging gun.

As shown in Figures 1 to 8, in another exemplary embodiment, the charging device is a charging gun suitable for mating with a charging seat, and the charging terminal 3 is suitable for mating with a mating terminal in the charging seat.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A cooling module, comprising:
a cooling box (1) comprising a containing chamber (101) for containing cooling liquid, an inlet pipe joint (11) and a cooling core pipe joint (12) communicated with the containing chamber (101); and
a fixing device (2) which is detachably installed on the cooling box (1) for fixing a single charging terminal (3) to the cooling box (1), so that the charging terminal (3) is in thermal contact with the cooling box (1),
wherein the inlet pipe joint (11) is used to connect with an inlet pipe (5) for supplying the cooling liquid, and the cooling core pipe joint (12) is used to connect with a cooling core pipe (42) of a charging cable (4), so that the cooling liquid can flow through the containing chamber (101) and the cooling core pipe (42) of the charging cable (4) to cool the charging terminal (3) and the charging cable (4).

2. The cooling module according to claim 1,
wherein the cooling box (1) comprises of:
a box body (10) which is used to define the containing chamber (101) and has an opening (101a); and
a cover plate (13) which is installed on the opening (101a) of the box body (10),
wherein the fixing device (2) is used to fix the charging terminal (3) to the outer surface of the cover plate (13), and the cover plate (13) is used to make thermal contact with the charging terminal (3), so that the heat of the charging terminal (3) can be transferred to the cooling liquid inside the cooling box (1) through the cover plate (13).

3. The cooling module according to claim 2,
wherein the inlet pipe joint (11) and the cooling core pipe joint (12) are integrally formed with the box body (10), so that the inlet pipe joint (11) and the cooling core pipe joint (12) become part of the box body (10); or
wherein the inlet pipe joint (11) and the cooling core pipe joint (12) are respectively connected to the box body (10) and communicated with the containing chamber (101).

4. The cooling module according to claim 2,
wherein the cover plate (13) is an insulation component that can conduct heat but not electricity, and the box body (10) is an insulation component that cannot conduct heat and electricity.

5. The cooling module according to claim 2,
wherein the cooling box (1) further comprises of:
a sealing ring (14) which is set around the opening (101a) of the box body (10) and compressed between the box body (10) and the cover plate (13) to achieve sealing between the box body (10) and the cover plate (13).

6. The cooling module according to claim 2,
wherein a threaded hole (102) is formed in the box body (10), and a connection hole (131) is formed in the cover plate (13), the cooling module (100) further comprises a threaded connecting piece (15), which passes through the connection hole (131) and is threaded into the threaded hole (102) to fix the cover plate (13) to the box body (10).

7. The cooling module according to claim 2,
wherein the fixing device (2) comprises of:
a U-shaped component (20) which is fastened onto the box body (10) and formed with a threaded connection hole (201); and
a bolt (23) which is connected to the threaded connection hole (201) for pushing the charging terminal (3) onto the cover plate (13) of the cooling box (1), so that there is a predetermined contact force between the charging terminal (3) and the cover plate (13).

8. The cooling module according to claim 7,
wherein the U-shaped component (20) comprises:
a pair of side plates (21) which are respectively fastened to both sides of the box body (10); and
a top plate (22) connected between the top of the pair of side plates (21) and facing the cover plate (13) of the cooling box (1),
wherein the threaded connection hole (201) is formed in the top plate (22) of the U-shaped component (20) and the axis of the threaded connection hole (201) is perpendicular to the outer surface of the cover plate (13).

9. The cooling module according to claim 8,
wherein the pair of side plates (21) of the U-shaped component (20) are respectively formed with snap slots (213), and protrusions (103) are respectively formed on both sides of the box body (10) of the cooling box (1), the protrusions (103) are engaged with the snap slots (213) to fix the pair of side plates (21) of the U-shaped component (20) to both sides of the box body (10) of the cooling box (1).

10. An electrical connection module, comprising:
the cooling module (100) according to any one of claims 1-9;
a charging terminal (3) which is fixed to the cooling box (1) of the cooling module (100) by the fixing device (2) of the cooling module (100); and
a charging cable (4) comprising a cooling core pipe (42) connected to the cooling core pipe joint (12) of the cooling module (100) and a conductor core (41) connected to the charging terminal (3),
wherein the charging terminal (3) is in thermal contact with the cooling box (1), so that the heat of the charging terminal (3) can be transferred to the cooling liquid inside the cooling box (1).

11. The electrical connection module according to claim 10,
wherein the conductor core (41) has a flat connection end (41 a), and the charging terminal (3) has a flat welding end (31a), the connection end (41 a) of the conductor core (41) is stacked and welded to the top surface of the welding end (31 a) of the charging terminal (3);
wherein the bolt (23) of the fixing device (2) is pressed against the connection end (11a) of the conductor core (41), so as to push the welding end (31) of the charging terminal (3) onto the cover plate (13) of the cooling box (1) through the connection end (41) of the conductor core (41), so that the bottom surface of the welding end (31) of the charging terminal (3) is in direct thermal contact with the outer surface of the cover plate (13).

12. The electrical connection module according to claim 10,
wherein the conductor core (41) of the charging cable (4) is tubular, and the cooling core pipe (42) is set in the tubular conductor core (41), the charging cable (4) also includes an outer insulation layer (43) wrapped around the outside of the conductor core (41).

13. The electrical connection module according to claim 10, further comprising:
an inlet pipe (5) which is connected to the inlet pipe joint (11) of the cooling module (100), and is used to supply cooling liquid to the cooling box (1) and the cooling core pipe (42) of the charging cable (4).

14. The electrical connection module according to claim 13, further comprising:
an elastic seal (6) which is formed with a first through-hole (61) that allows the charging cable (4) to pass through and a second through-hole (62) that allows the inlet pipe (5) to pass through,
wherein the charging cable (4) and the inlet pipe (5) pass through the elastic seal (6), and the elastic seal (6) is adapted to be installed into a rear port (801) of a housing (8) of a charging device to seal the rear port (801) of the housing (8).

15. The electrical connection module according to claim 14, further comprising:
a rear end cap (7) which is formed with a third through-hole (71) that allows the charging cable (4) to pass through and a fourth through-hole (72) that allows the inlet pipe (5) to pass through,
wherein the charging cable (4) and the inlet pipe (5) pass through the rear end cap (7), the rear end cap (7) is adapted to be locked onto the peripheral wall of the rear port (801) of the housing (8) to fix the elastic seal (6) in the rear port (801) of the housing (8).

16. A charging device, comprising:
a housing (8); and
the electrical connection module (200) according to any one of claims 10-15, inserted into the housing (8).

17. The charging device according to claim 16,
wherein the housing (8) has multiple mounting holes (81), and the charging device comprises multiple electrical connection modules (200), which are respectively inserted into the multiple mounting holes (81) of the housing (8).
